(19) Europäisches Patentamt / European Patent Office / Office européen des brevets

(11) **EP 4 421 888 A1**

(12) **EUROPEAN PATENT APPLICATION**
published in accordance with Art. 153(4) EPC

(43) Date of publication:
**28.08.2024 Bulletin 2024/35**

(21) Application number: **22951455.9**

(22) Date of filing: **19.07.2022**

(51) International Patent Classification (IPC):
**H01L 33/38** *(2010.01)*      **H01L 33/58** *(2010.01)*

(52) Cooperative Patent Classification (CPC):
**H01L 33/38; H01L 33/58**

(86) International application number:
**PCT/CN2022/106563**

(87) International publication number:
**WO 2024/016177 (25.01.2024 Gazette 2024/04)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **BOE Technology Group Co., Ltd.**
**Beijing 100015 (CN)**

(72) Inventors:
• **ZHANG, Jingjing**
**Beijing 100176 (CN)**

• **WANG, Can**
**Beijing 100176 (CN)**
• **CHEN, Xiaochuan**
**Beijing 100176 (CN)**
• **XUAN, Minghua**
**Beijing 100176 (CN)**
• **ZHANG, Can**
**Beijing 100176 (CN)**
• **CONG, Ning**
**Beijing 100176 (CN)**
• **NIU, Jinfei**
**Beijing 100176 (CN)**

(74) Representative: **Lavoix**
**Bayerstraße 83**
**80335 München (DE)**

(54) **DISPLAY PANEL, DISPLAY APPARATUS AND MANUFACTURING METHOD FOR DISPLAY PANEL**

(57)    Embodiments of the present application provide a display panel, a display device, and a method for manufacturing the display panel. The display panel includes a substrate, a light emitter, a first electrode and a light collimating unit. The light emitter is on a side of the substrate. The first electrode is on a side of the light emitter away from the substrate. The light collimator is on a side of the first electrode away from the substrate, and the light collimator includes at least one microstructure, in a direction away from the substrate, a cross-sectional area of each of the at least one microstructure decreases. The manufacturing method is used to manufacture the display panel. The display panel of the embodiment of the present application has a high light exiting rate, and a good effect of emitting collimated light.

FIG. 1

EP 4 421 888 A1

## Description

## TECHNICAL FIELD

The present application relates to a field of display technology, and in particular to display panels, display devices and methods of manufacturing a display panel.

## BACKGROUND

A micro light-emitting diode (Micro LED) is a light-emitting device that uses an inorganic material (such as gallium nitride) as a light-emitting material. A display device using Micro LED as a light emitting device has advantages of fast response speed and high stability.

The light emitted by micro light-emitting diode display panel in related art has characteristics of point light sources, and in use, some of the light cannot be utilized, resulting in problems such as low light exiting rate and poor collimation light effect.

## SUMMARY

The present application provides display panels, display devices and methods of manufacturing a display panel.

A first aspect of embodiments of the present application provides a display panel. The display panel includes:

a substrate;
a light emitter on a side of the substrate;
a first electrode on a side of the light emitter away from the substrate; and
a light collimator on a side of the first electrode away from the substrate, where the light collimator includes at least one microstructure, and where in a direction away from the substrate, a cross-sectional area of each of the at least one microstructure decreases.

In this application, a refractive index of a material (that is, the first electrode) on a side of the light collimator towards the substrate is different from a refractive index of a material on a side of the light collimator away from the substrate. By setting the at least one microstructure and gradually decreasing the cross-sectional areas of the at least one microstructure, when the display panel emitting light, the light collimator can reduce an impact of reflection on the light emitted by the light emitter, which is beneficial for improving a brightness of the display panel. The light collimator is also beneficial for reducing a refractive angle of outgoing light and facilitating the display panel to emit collimated light. The display panel of the present application can achieve better display effects in some application scenarios such as display backlight, VR (Virtual Reality), AR (Augmented Reality) near-eye display, and anti-spy screen display.

In an embodiment, a filler is provided between adjacent light emitters.

In an embodiment, a distance from a surface of the filler away from the substrate to the substrate is greater than or equal to a distance from a surface of the light collimator away from the substrate to the substrate.

In an embodiment, the filler includes a reflective material.

In an embodiment, a projection of the light collimator onto the substrate covers at least a projection of the light emitter onto the substrate.

In an embodiment, a plurality of adjacent first electrodes are connected with each other.

In an embodiment, the at least one microstructure includes a nanostructure and/or a condenser lens.

In an embodiment, the nanostructure includes a bottom in contact with the first electrode, and bottoms of adjacent nanostructures are connected with one another.

In an embodiment, a material of the first electrode is the same as a material of the nanostructure, and the first electrode is integrally connected with the nanostructure. In an embodiment, a filler is provided between adjacent light emitters; in a thickness direction of the substrate, a thickness of the nanostructure ranges from 200 nm to 250 nm; and a surface of the filler away from the substrate is at least 250 nm farther away than a surface of the first electrode away from the substrate. In an embodiment, the condenser lens is a spherical cap, and a projection of the condenser lens onto the substrate covers at least a projection of the light emitter onto the substrate. In an embodiment, a filler is provided between adjacent light emitters; in a thickness direction of the substrate, a thickness of the condenser lens ranges from 2 $\mu$m to 3 $\mu$m; a surface of the filler away from the substrate is at least 3 $\mu$m farther away than a surface of the first electrode away from the substrate.

In an embodiment, a material of the substrate includes a silicon material. In an embodiment, the light emitter includes a first semiconductor layer, a light emitting layer, and a second semiconductor layer that are stacked in sequence; where the light emitting layer includes a quantum well layer, and the first semiconductor layer is a second electrode. In an embodiment, the display panel further includes an encapsulation layer, the encapsulation layer is on a side of the light collimator away from the substrate, and is filled between adjacent microstructures, and a refraction index of the encapsulation layer is smaller than a refraction index of the microstructure.

In an embodiment, the substrate includes a driving circuit layer, and the driving circuit layer is configured to drive the light emitter.

In an embodiment, the display panel includes a bonding metal pad, the bonding metal pad is disposed between the substrate and the light emitter, and the driving circuit layer is configured to drive the light emitter through the bonding metal pad.

A second aspect of the embodiments of the present application provides a display device, where the display device includes the above-mentioned display panel.

A third aspect of the embodiments of the present application provides a method of manufacturing a display panel, and the method is used to manufacture the above-mentioned display panel. The manufacturing method includes:

forming an epitaxial layer on a side of a support substrate, where the epitaxial layer comprises a second semiconductor layer, a light emitting layer, and a first semiconductor layer that are stacked in sequence;

forming a bonding metal layer on a side of the epitaxial layer away from the support substrate;

bonding the epitaxial layer to a substrate by the bonding metal layer;

removing the support substrate, and patterning the epitaxial layer to form a plurality of light emitters;

forming a first electrode on a side of the plurality of light emitters away from the substrate;

forming a light collimator on a side of the first electrode away from the substrate, where the light collimator includes at least one microstructure, and in a direction away from the substrate, a cross-sectional area of each of the at least one microstructure decreases.

In an embodiment, in response to determining that the at least one microstructure includes a nanostructure, the nanostructure is manufactured by: first forming a metal layer on the first electrode, and etching the metal layer to form the nanostructure; or directly etching the first electrode to form the nanostructure.

In an embodiment, in response to determining that the at least one microstructure includes a nanostructure, the nanostructure is manufactured by:

forming a photoresist pattern on a side of the first electrode away from the substrate, where the photoresist pattern includes a plurality of sub-patterns, and a cross-sectional area of each of the plurality of sub-patterns decreases; and

dry etching the first electrode using the photoresist pattern as a mask, and such that a topography of the photoresist pattern is transferred to the first electrode to form the nanostructure.

It is to be understood that both the foregoing general description and the following detailed description are exemplary and explanatory only and are not restrictive of the application.

## BRIEF DESCRIPTION OF THE DRAWINGS

The accompanying drawings, which are incorporated in and constitute a part of this specification, illustrate embodiments consistent with the application and together with the description serve to explain the principles of the application.

FIG. 1 is a partial cross-sectional view of a display panel according to an embodiment of the present application;

FIG. 2 is a top view of a light emitter of a display panel according to an embodiment of the present application;

FIG. 3 is a partial cross-sectional view of a first electrode and a light collimator according to an embodiment of the present application;

FIG. 4 is an equivalent refractive index fitting curve of a pyramid-shaped nanostructure according to an embodiment of the present application;

FIG. 5 is a partial cross-sectional view of a first electrode and a light collimator according to an embodiment of the present application;

FIG. 6 is a partial cross-sectional view of a first electrode and a light collimator according to another embodiment of the present application;

FIG. 7 is a partial cross-sectional view when the microstructure of the display panel only includes a nano-unit, according to an embodiment of the present application;

FIG. 8 is a partial cross-sectional view when the microstructure of the display panel only includes a condenser lens, according to an embodiment of the present application;

FIG. 9 is a partial cross-sectional view of a support substrate and an epitaxial layer according to an embodiment of the present application;

FIG. 10 is a partial cross-sectional view when a support substrate and an epitaxial layer are bonded to the substrate according to an embodiment of the present application;

FIG. 11 is a partial cross-sectional view of an epitaxial layer bonded to a substrate according to an embodiment of the present application;

FIG. 12 is a partial cross-sectional view of light emitters formed by patterning an epitaxial layer according to an embodiment of the present application;

FIG. 13 is a partial cross-sectional view of a display panel according to an embodiment of the present application;

FIG. 14 is a partial cross-sectional view of a display panel according to another embodiment of the present application;

FIG. 15 is a partial cross-sectional view of a display panel according to another embodiment of the present application;

FIG. 16 is a schematic diagram of a manufacturing process of a nanostructure according to an embodiment of the present application.

**DETAILED DESCRIPTION OF THE EMBODIMENTS**

Reference will now be made in detail to the exemplary embodiments, examples of which are illustrated in the accompanying drawings. When the following description refers to the accompanying drawings, unless otherwise indicated, the same numbers in different drawings represent the same or similar elements. The implementations described in the following exemplary embodiments do not represent all implementations consistent with this application. On the contrary, they are merely examples of apparatuses and methods consistent with aspects of the present application as recited in the appended claims.

The terminology used in this application is for the purpose of describing particular embodiments only, and is not intended to limit the application. As used in this application and the appended claims, the singular forms "a", "said", and "the" are intended to include the plural forms as well, unless the context clearly dictates otherwise.

It should be understood that "first," "second" and similar words used in the specification and claims of this application do not indicate any order, quantity or importance, but are only used to distinguish different components. Likewise, words like "a" or "one" do not denote a limitation in quantity, but indicate that there is at least one. Unless otherwise indicated, terms such as "front," "rear," "lower" and/or "upper" are used for convenience of description only and are not intended to be limiting to a position or orientation in space. "Include" or "comprise" and similar terms mean that the elements or items presented before "include" or "comprise" include the elements or items listed after "include" or "comprise" and their equivalents, and do not exclude other elements or items.

The display panels, the display devices, and the methods of manufacturing the display panel according to the embodiments of the present application will be described in detail below with reference to the accompanying drawings. In the case of no conflict, the features in the following embodiments and implementation manners can complement each other or be combined with each other.

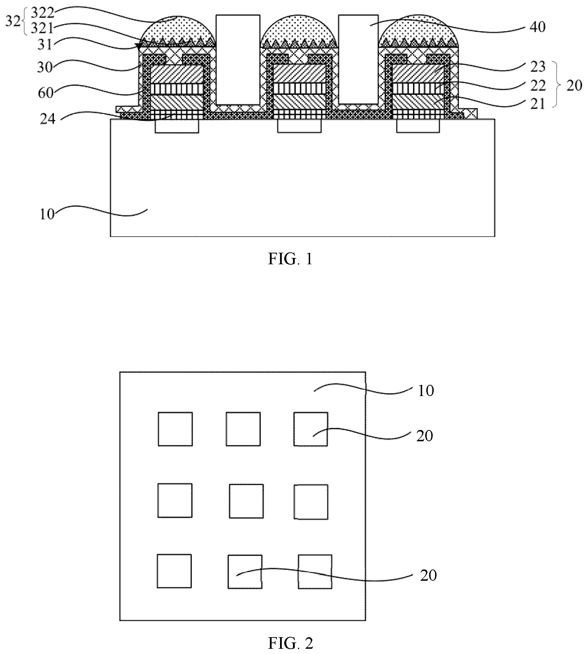

The present application provides a display panel. As shown in FIG. 1, the display panel includes a substrate 10, a light emitter 20, a first electrode 30, and a collimation unit 31. The light emitter 20 is on a side of the substrate 10. The first electrode 30 is on a side of the light emitter 20 away from the substrate 10. The light collimator 31 is on a side of the first electrode 30 away from the substrate 10, the light collimator 31 includes at least one microstructure 32, and in a direction away from the substrate 10, a cross-sectional area of each of the at least one microstructure 32 decreases.

The light emitted by light emitter in related display panel has characteristics of point light sources, after the light emitted by the light emitter is reflected or refracted, some of the light cannot emitted from the display panel, resulting in a low light exiting rate of the display panel. After the light emitted by the light emitter is refracted, the light is deflected, resulting in poor emission of collimated light from the display panel, ultimately resulting in poor display performance.

In this application, a material on a side of the light collimator 31 towards the substrate 10 (that is, the first electrode) has a different refractive index from a material on a side of the light collimator 31 away from the substrate 10. By setting the microstructure 32 and gradually reducing the cross-sectional area of the microstructure 32, when the display panel emits light, the light collimator 31 can reduce an influence of reflection on the light emitted by the light emitter 20, thereby helping to improve the brightness of the display panel, and the light collimator 31 is conducive to reducing a refraction angle of emission light, and is beneficial to make the display panel emit collimated light. The display panel of the present application can achieve better display effects in some application scenarios such as display backlight, VR (Virtual Reality), AR (Augmented Reality) near-eye display, and anti-spy screen display.

In an embodiment, as shown in FIG. 1, the substrate 10 is a silicon substrate 10. The display panel of the silicon substrate 10 emits light from single side, with good light directionality and good light quality, and is suitable for application scenarios that have requirements on the light emission angle. Furthermore, an area of the driving circuit layer can be manufactured smaller by using the silicon substrate, which is beneficial to improve the resolution of the display panel.

In an embodiment, the substrate 10 includes a driving circuit layer, and the driving circuit layer is configured to drive the light emitter 20. The driving circuit layer includes a driving circuit, for example, a circuit including three transistors and a capacitor, or other types of driving circuits.

In an embodiment, the driving circuit layer can include a capacitor and a transistor, and the transistor can be a thin film transistor (TFT) or a metal oxide semiconductor transistor (MOS).

In an embodiment, the substrate 10 made of silicon can be referred to as a driving backplane. The driving backplane provided by the embodiment of the present application can include a Poly-Si layer and multiple metal layers. The type of the driving backplane can include 1P6M, 1P5M or 1P8M. Taking the 1P6M type of driving backplane as an example, it includes one Poly-Si layer and six metal layers. The Poly-Si layer is configured to manufacture an active layer of the transistor, and the six metal layers are jointly configured to form conductive patterns.

In an embodiment, the display panel includes a bonding metal pad 24 disposed between the substrate 10 and the light emitter 20, and the driving circuit layer is configured to drive the light emitter through the bonding metal pad 24. The material of the bonding metal pad 24 can include Cu-Sn alloy, Sn-Ag alloy, Sn-In alloy, Sn-Au alloy, Au-In alloy, Cu-In alloy and other materials.

In an embodiment, the light emitter 20 includes a first semiconductor layer 21, a light emitting layer 22 and a second semiconductor layer 23 that are stacked in sequence, where the light emitting layer 22 includes a quantum well layer. The first electrode 30 can be a cathode, the first semiconductor layer 21 can be a P-type semiconductor layer, and the second semiconductor layer 23 can be an N-type semiconductor layer, where the N-type semiconductor layer can include N-type gallium nitride (N-GaN), and the P-type semiconductor sublayer can include P-type gallium nitride (P-GaN). The first semiconductor layer 21 can be the second electrode of the light emitter 20, and the second electrode can be an anode. The first semiconductor layer 21 is electrically connected with the driving circuit layer through the bonding metal pad 24.

In an embodiment, as shown in FIG. 2, a shape of the light emitting layer 22 can be a square, that is, the shape of the light emitter 20 can be a square, and a side length of the square can range from 4 μm~6 μm. For example, the side length of the light emitting layer 22 can be 4 μm, 4.5 μm, 5 μm, 5.5 μm, 6 μm and so on. In some other embodiments, a shape of the light emitting layer 22 can also be in other shapes such as a circle, and its specific size can be set according to the display requirements of the display panel, which is not specifically limited here.

In an embodiment, the light emitter 20 is used to form a Micro LED (Micro Light Emitting Diode). And, a size of Micro LED ranges from 0 μm to100 μm. In some other embodiments, the light emitter 20 can also be used to form a Mini LED (Mini Light Emitting Diode), where the size of the Mini LED ranges from 100 μm to 300 μm.

In an embodiment, as shown in FIG. 1, the display panel includes an insulation layer 60 on the second semiconductor layer 23, the insulation layer 60 is provided with an opening above the second semiconductor layer 23, and the first electrode 30 is connected with the second semiconductor layer 23 through the opening. In some embodiments, the insulating layers 60 can be connected with each other to form a whole insulation layer, and the insulation layer 60 is disposed above the second semiconductor layer 23 and between light emitters 20.

In an embodiment, a plurality of adjacent first electrodes 30 are connected with each other. Many light emitters 20 can be divided into a plurality of groups, and the first electrodes 30 of light emitters 20 in each group are connected with each other. It is also possible to connect the first electrodes 30 of all light emitters 20 with each other to form a whole electrode layer. The plurality of interconnected first electrodes 30 are disposed not only on the light emitters 20 but also on the insulation layer 60 between the light emitters 20, and the plurality of interconnected first electrodes 30 constitute a common electrode of the plurality of light emitters 20. This arrangement is beneficial to reduce a size of the light emitter 20 and improve the resolution of the display panel. In some other embodiments, the first electrode 30 can also be patterned.

In an embodiment, a projection of the light collimator 31 onto the substrate 10 covers at least a projection of the light emitter 20 onto the substrate 10. This arrangement can ensure that light emitted by the light emitter 20 passes through the light collimator 31 and then exits the display panel, which is beneficial to reduce a refraction angle of the outgoing light and make the display panel emit collimated light.

In an embodiment, the display panel further includes an encapsulation layer 50, the encapsulation layer 50 is on a side of the light collimator 31 away from the substrate 10, and is filled between adjacent microstructures, and a refraction index of the encapsulation layer 50 is smaller than a refraction index of the microstructures 32. With this arrangement, the encapsulation layer 50 can provide protection for the light emitter 20 and other layers, which is beneficial to improve the stability of the display panel. The above arrangement is also beneficial to reduce the influence of refraction and reflection on the light emitted by the light emitter 20, and is beneficial to improve the brightness of the display panel. In some embodiments, a material of the encapsulation layer 50 can include organic silica gel, epoxy resin and other materials.

In an embodiment, as shown in FIG. 1, a filler 40 is provided between two light emitters 20. The filler 40 is filled in a gap between the light emitters 20, which is beneficial to increase the stability of the display panel. When the display panel includes the encapsulation layer 50, the filler 40 can support the encapsulation layer 50, thereby reducing the stress of the layer(s) under the encapsulation layer 50.

In an embodiment, the filler can include a reflective material. For example, the material of the filler 40 can include reflective white glue. In a case that color of light emitted by respective light emitters 20 is the same, a material of the filler 40 can be white glue, and some of the light emitted by the light emitting layer 22 can be reflected by the surface of the filler 40 during transmission, and the reflected light can be emitted out of the display panel, which is conducive to further improving the light exiting rate of the display panel and improving a forward light emission effect of the display panel. In other embodiments, in a case that the color of light emitted by respective light emitters 20 is different, the filler can also be dark-colored glue such as black or gray glue. When the material of the filler 40 is dark-colored glue such as black or gray glue, some of the light emitted by the light emitting layer 22 is absorbed by the filler 40, which can avoid color crossing between different light emitters 20.

In an embodiment, a distance from a surface of the filler away from the substrate to the substrate is greater than or equal to a distance from a surface of the light collimator away from the substrate to the substrate. In this way, when the encapsulation layer 50 is disposed above the light collimator 31, the encapsulation layer 50 directly covers the microstructure 32, and the existence of the filler 40 can support and protect the microstructure 32, supporting part of the encapsulation layer 50, such that deformation of the microstructure 32 under force is avoided when subsequent layers such as the encapsulation layer 50 are manufactured in the display panel.

In an embodiment, the microstructure 32 includes a nanostructure 321 and/or a condenser lens 322.

The design principle of the nanostructure 321 is as follows.

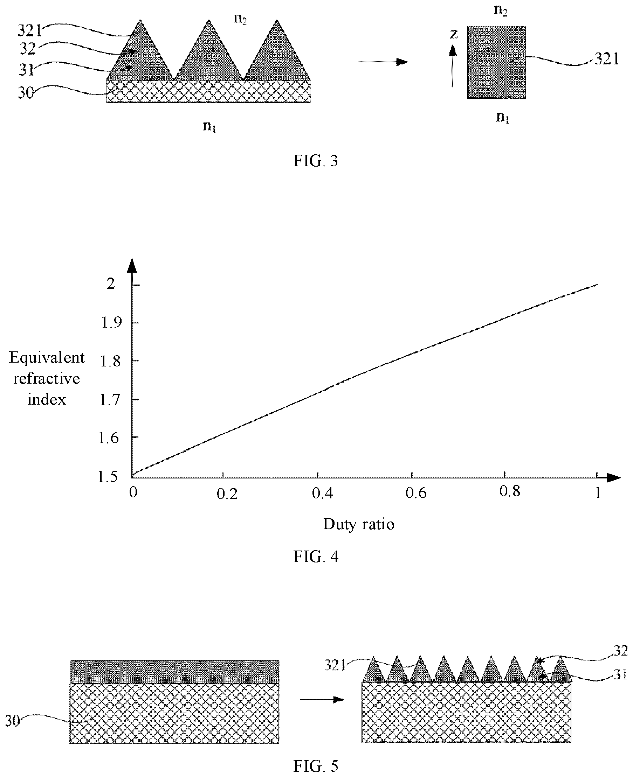

A nanostructure with a smaller period can be referred as to a zero-order diffraction grating. When a plane wave passes through the nanostructure, its wavefront (wave front) does not change, which is similar to a plane wave passing through a dielectric coating. An equivalent refractive index of the nanostructure is determined by the effective medium theory. As shown in FIG. 1, the light collimator 31 in this application includes a plurality of nanostructures 321, where the microstructure with a size smaller than 1000 nm can be regarded as a nanostructure in this application. When the light passes through the light collimator 31, a specific outline of the nanostructure 321 cannot be recognized by the light, and only zero-order diffraction exists. At this time, the nanostructure 321 can be equivalent to a layer of homogeneous medium. The nanostructure 321 can be considered to be formed by stacking multiple layers in a direction of layer stacking. Since the cross-sectional area of the nanostructure 321 decreases in the direction of layer stacking from the substrate 10 pointing to the light collimator 31, the areas of the layers regarded as constituting the nanostructure 321 also decrease in the direction of the layer stacking from the substrate 10 pointing to the light collimator 31, as shown in FIG. 1 and FIG. 3(where $n_1$ is greater than $n_2$). According to the formula for calculating the equivalent refractive index:

$$n_{eff}^2 = f n_1^2 + (1-f) n_2^2$$

(where $n_{eff}$ indicates the equivalent refractive index; f indicates the duty ratio of each layer; $n_1$ indicates the refractive index of the material on a side of the light collimator 31 facing the substrate 10; $n_2$ indicates the refractive index of the material on a side of the nanostructure 321 away from the substrate 10.)

It can be seen that the equivalent refractive index of the light collimator 31 gradually changes from $n_1$ to $n_2$ in the direction of the layer stacking from the substrate 10 to the light collimator 31 (that is, in the z direction in FIG. 3). According to the Fresnel reflection theory, when light propagates from a medium with a refractive index of $n_1$ (the medium with a refractive index of $n_1$ in FIG. 3 is an optically dense medium) to another medium with a refractive index of $n_2$ (the medium with a refractive

index of $n_2$ in FIG. 3 is an optically sparse medium), light reflection can occur at the junction of two media with different refractive indices, and the greater the difference in refractive index between the two media, the easier it is for light to reflect at the interface between the two media. According to the refraction formula, when light enters from an optically dense medium with a refractive index of $n_1$ into an optically sparse medium with a refractive index of $n_2$ at a same angle, the greater the difference between the refractive index $n_1$ and the refractive index $n_2$ is, the greater the outgoing angle of the light is. The nanostructure 321 in the present application can achieve a uniform transition of the refractive index between two different media, thereby helping to reduce the reflection of the layers on the light emitted by the light emitter 20, improving the brightness of the display panel, and helping to reduce the refraction angle of the outgoing light, and make the display panel emit collimated light.

In an embodiment, the nanostructure 321 includes a bottom that is in contact with the first electrode 30, and bottoms of adjacent nanostructures 321 are connected with one another. The nanostructures 321 with bottoms interconnected can make the contact area between the light collimator 31 and the first electrode 30 larger, thereby facilitating the uniform transition of the refractive index from the side of the light collimator 31 facing the substrate 10 to the side of the light collimator 31 away from the substrate 10.

In an embodiment, the nanostructure 321 includes a top portion away from the first electrode 30, and the top portion of the nanostructure 321 can be a point-shaped or a line-shaped tip. Taking the case where a sum of areas of the bottoms of the nanostructures 321 towards the substrate 10 is the same as an area of the first electrode 30 as an example, according to the calculation formula of the equivalent refractive index, it can be known that a duty ratio f of the bottommost layer among the layers constituting the nanostructure 321 is 1, and the equivalent refractive index of the bottommost layer is $n_1$. When the top portion of the nanostructure 321 is a point-like or linear tip, a duty ratio f of the topmost layer among the layers constituting the nanostructure 321 can be regarded as 0, and the equivalent refractive index of the topmost layer is $n_1$. Taking the encapsulation layer 50 on the side of the nanostructure 321 away from the substrate 10 as an example, with the above arrangement, the equivalent refractive index of the junction between the nanostructure 321 and the first electrode 30 is the same as the equivalent refractive index of the first electrode 30, and the equivalent refractive index of the junction between the nanostructure 321 and the encapsulation layer 50 is the same as the equivalent refractive index of the encapsulation layer 50. In the direction from the first electrode 30 to the encapsulation layer 50, uniform changes in the refractive index between the layers can be achieved by the nanostructure 321, which is more conducive to improving the brightness of the display panel and the emission of collimated light.

In an embodiment, a shape of the nanostructure 321 included in the microstructure 32 of the light collimator 31 can be a pyramid shape, the duty ratio f of the bottom surface of the pyramid array formed by the plurality of nanostructures 321 is 1, a side length of the bottom surface of the nanostructure 321 ranges from 270 nm to 330 nm, a lattice constant of the nanostructure 321 ranges from 270 nm to 330 nm, and a thickness of the nanostructure 321 ranges from 200 nm to 250 nm. In the direction where the substrate 10 points to the light collimator 31, the cross-sectional area of the nanostructure 321 with the pyramid-shaped decreases, and the equivalent refractive index of the nanostructure 321 decreases. Configuring the nanostructure 321 in a pyramid shape is more convenient for manufacturing and processing the light collimator 31, and in other embodiments, the shape of the nanostructure 321 can also be a spherical cap shape or other shapes.

In this embodiment, the side of the nanostructure 321 towards the substrate 10 is the first electrode 30 (the first electrode 30 can be a cathode), and the refractive index of the first electrode 30 is 2.0. The side of the light collimator 31 away from the substrate 10 is an encapsulation layer 50, and the refraction index of the encapsulation layer 50 is 1.5. As shown in FIG. 4, the figure is the equivalent refractive index fitting curve of the pyramid-shaped nanostructure 321. It can be seen from the figure that as the duty ratio of the nanostructure 321 decreases, the equivalent refractive index of the nanostructure 321 gradually changes from 2 to 1.5, which changes linearly, and the equivalent refractive index changes uniformly. When the light passes through the first electrode 30 and the encapsulation layer 50, due to the existence of the nanostructure 321, the light reflection (especially the total reflection) phenomenon can be weakened, which is beneficial to improve the light exiting rate, and at the same time, it is beneficial to emit collimated light.

In an embodiment, as shown in FIG. 5, the nanostructure 321 is formed by etching after disposing a metal layer on the first electrode 30.

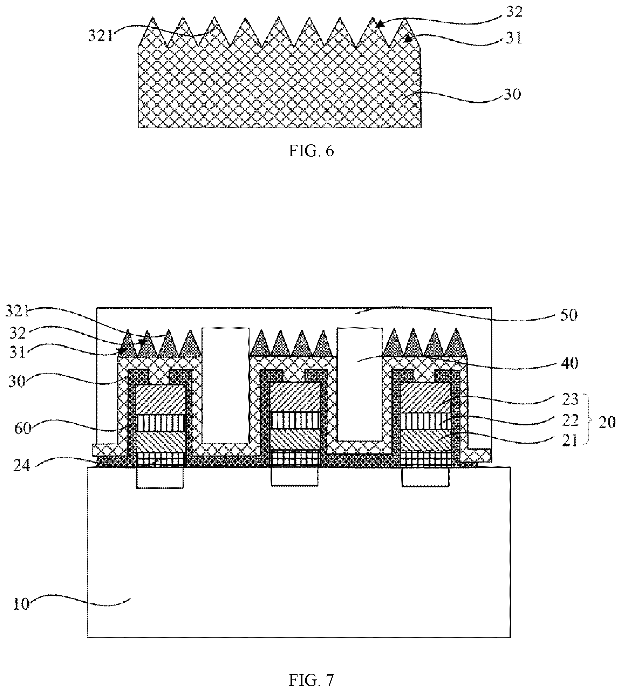

In an embodiment, as shown in FIG. 6, a material of the first electrode 30 is the same as that of the nanostructure 321, and the first electrode 30 and the nanostructure 321 are integrally connected. That is, the first electrode 30 can be directly etched to form the nanostructure 321, which is beneficial to simplify the manufacturing process of the nanostructure 321.

In an embodiment, as shown in FIG. 7, in the thickness direction of the substrate 10, the thickness of the nanostructure 321 ranges from 200 nm to 250 nm; the surface of the filler 40 away from the substrate 10 is at least 250 nm farther away than the surface of the first electrode 30 away from the substrate 10. The thickness of the nanostructure 321 can be, for example, 200 nm, 220 nm, 240 nm, 250 nm and so on. If the size of the nanostructure 321 is too small, the equivalent refractive index of the nanostructure changes too quickly; if the size of the nanostructure 321 is too large, the nanostructure 321 may produce other diffraction. When the nanostructure 321 is designed in the above ranges, it is beneficial to improve the light exiting rate of the display panel and make the display panel emit collimated light. The filler 40 is at least 250 nm farther away than the electrode. When the encapsulation layer 50 is provided above the nanostructure 321, the encapsulation layer 50 directly covers the nanostructure 321. The filler 40 can support and protect the nanostructure 321, support part of the encapsulation layer 50, and prevent the nanostructure 321 from being deformed by force when the encapsulation layer 50 and other subsequent layers are manufactured for the display panel. In some embodiments, the range of the thickness of the nanostructure 321 can be changed according to the size of the light emitter 20.

In an embodiment, fillers 40 can be connected with each other to form a whole support layer. The whole support layer has a better support performance for the light collimator 31.

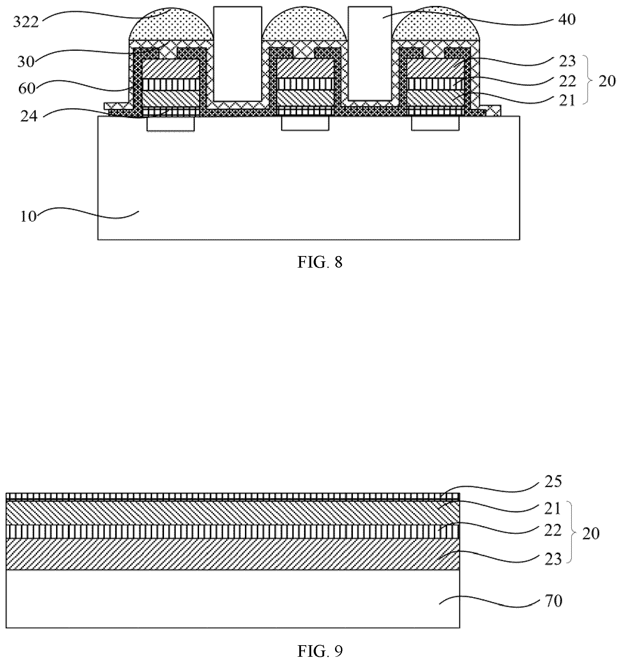

In an embodiment, as shown in FIG. 8, the display panel includes a condenser lens 322 located on a side of the first electrode 30 away from the substrate 10. After the light emitted from the light emitting layer 22 is emitted through the first electrode 30, some of the light still has a relatively large angle with the direction perpendicular to the substrate 10, that is, some of the light still cannot vertically emit from the display panel. By setting the condenser lens 322, when some of the light is emitted through the condenser lens 322, the light is further deflected, reducing the angle between the some of the light and the direction perpendicular to the substrate 10, which is beneficial for the display panel to emit collimated light.

In an embodiment, the condenser lens 322 is a spherical cap, and a projection of the condenser lens 322 onto the substrate 10 covers at least the projection of the light emitter 20 onto the substrate 10. The spherical cap structure is more advantageous for light to deflect and then emit out of the display panel, and the above arrangement is conducive to making all the light emitted by the light emitter 20 enter the condenser lens 322, and is more conducive to reducing the refraction angle of the outgoing light, such that the display panel emits collimated light.

In an embodiment, the encapsulation layer 50 is not provided after the condenser lens 322 is installed in the display panel, at this time, the condenser lens 322 not only functions to emit collimated light, but also replaces the encapsulation layer 50 to encapsulate and protect the underlying layers. In an embodiment, as shown in FIG. 8, adjacent light emitters 20 are provided with a filler 40, and a distance between the surface of the filler 40 on a side away from the substrate 10 to the substrate 10 is greater than or equal to a distance between the surface of the condenser lens 322 on the side away from the substrate to the substrate 10. When other layers are arranged above the condenser lens 322, for example, when a glass cover is provided above the condenser lens 322, the glass cover directly covers the condenser lens 322.

With the above arrangement, the filler 40 supports other layers such as the glass cover to prevent the condenser lens 322 from being deformed under pressure.

In addition to that, after a portion of the light is emitted from the condenser lens 322, it can be reflected by the filler 40, causing this portion of light to be emitted from the display panel, and the combination of the condenser lens 322 and the filler 40 is also conducive to improving the light extraction effect of the display panel.

In an embodiment, in the thickness direction of the substrate 10, the thickness of the condenser lens 322 ranges from 2 $\mu$m to 3 $\mu$m, and the surface of the filler 40 on the side away from the substrate 10 is at least 3 $\mu$m farther away than the surface of the first electrode 30 on the side away from the substrate 10. The radius of the condenser lens 322 can be, for example, 2 $\mu$m, 2.5 $\mu$m, 3 $\mu$m and so on. If the size of the condenser lens 322 is too small, some of the light cannot enter the condenser lens 322; if the size of the condenser lens 322 is too large, it will affect the arrangement of other layers. When the condenser lens 322 is configured in the above ranges, the size of the condenser lens 322 matches the size of the light emitter 20, and most of the light can enter the condenser lens 322 and deflect after passing through the condenser lens 322, which is beneficial for the display panel to emit collimated light.

In an embodiment, as shown in FIG. 1, the microstructure 32 of the light collimator 31 includes a nanostructure 321 and a condenser lens 322 at the same time. When the display panel emits light, the above arrangement is more conducive to reducing the influence of reflection (especially total reflection) on the light emitted by the light emitter 20, thereby helping to improve the brightness of the display panel, and more conducive to reducing the refraction angle of the outgoing light, and more conducive to making the display panel emit collimated light.

In an embodiment, as shown in FIG. 7 and FIG. 8, the microstructure 32 of the light collimator 31 can include only the nanostructure 321 or the condenser lens 322. The nanostructure 321 or the condenser lens 322 can be directly disposed on the first electrode 30, and relying solely on the nanostructure 321 or the condenser lens 322 can also improve the light output effect of the display panel.

Embodiments of the present application further provide a display device, the display device including the display panel described in any one of the above embodiments. The display device provided in the embodiment of the present application can be, for example, any device with a display function such as an AR (Augmented Reality) device or a VR (virtual reality) device.

The display device provided by the embodiments of the present application can include a plurality of display panels described in any of the above embodiments. A plurality of the display panels can be spliced together to form the display device.

Based on the same inventive concept, embodiments of the present application also provide a method of manufacturing a display panel, and the method is used for manufacturing the above-mentioned display panel. The manufacturing method includes:

at step 100: as shown in FIG. 9, forming an epitaxial layer on a side of a support substrate 70, where the epitaxial layer includes a second semiconductor layer 23, a light emitting layer 22, and a first semiconductor layer 21 that are stacked in sequence;

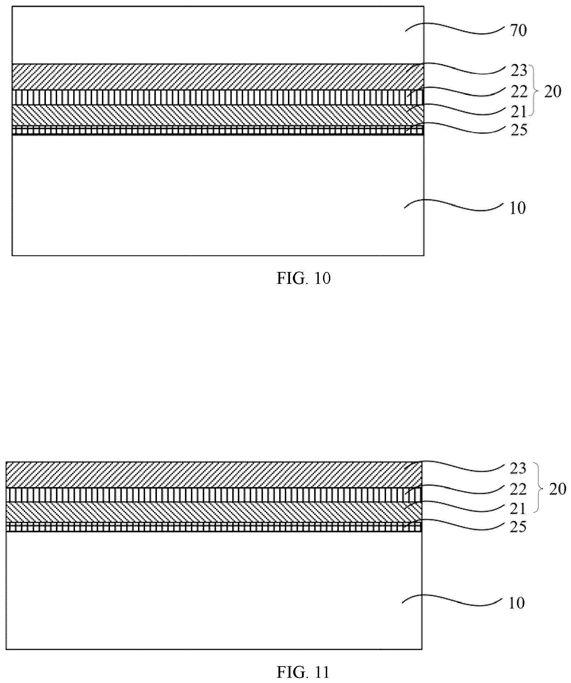

at step 200: as shown in FIG. 10, forming a bonding metal layer 25 on a side of the epitaxial layer away from the support substrate 70, and bonding the epitaxial layer to a substrate 10 by the bonding metal layer 25;

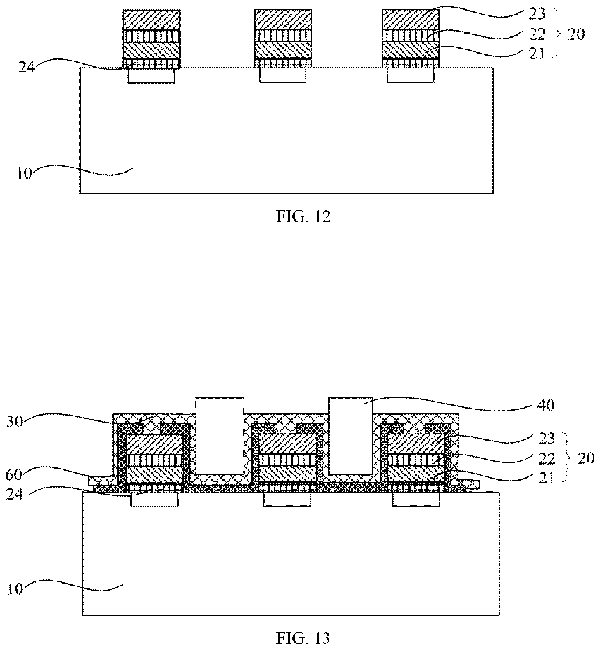

at step 300: as shown in FIG. 11 and FIG. 12, removing the support substrate 70, and patterning the epitaxial layer to form a plurality of light emitters 20;

at step 400: as shown in FIG. 13, forming a first electrode 30 on a side of the plurality of light emitters 20 away from the substrate 10;

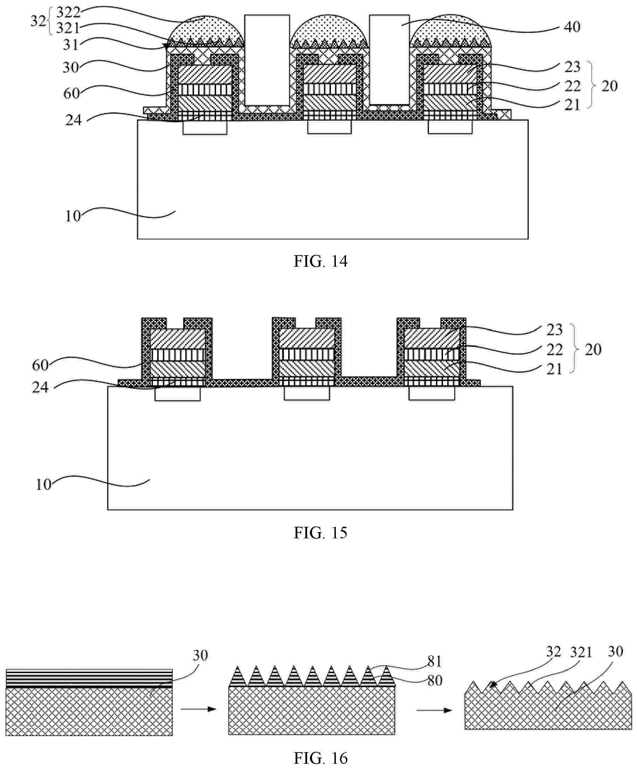

at step 500: as shown in FIG. 14, forming a light collimator 31 on a side of the first electrode 30 away from the substrate 10, where the light collimator 31 includes at least one microstructure 32, and in a direction away from the substrate 10, a cross-sectional area of each of the at least one microstructure 32 decreases.

In the step 100, the support substrate 70 is a silicon support substrate, and using the silicon support substrate 70 to manufacture an epitaxial layer can increase a utilization rate of the epitaxial area, which is beneficial to improve the production efficiency and yield of the light emitters 20. And in the subsequent step 300, the silicon support substrate 70 can be removed directly by hydrofluoric acid etching process. This removal method can avoid damage to the epitaxial layer during the process of removing the support substrate 70, and can reduce the difficulty of peeling the support substrate 70.

In the step 100, the epitaxial layer can be deposited on the support substrate 70 by using MOCVD (Metal Organic Chemical Vapor Deposition) process. In some embodiments, a second semiconductor layer 23 (N-type GaN layer) is first manufactured on the support substrate 70, and then a light emitting layer 22 (multi-layer quantum well layer) is manufactured, and then a first semiconductor layer 21 (P-type GaN layer) is manufactured.

In the step 200, the material of the bonding metal layer 25 can include one of Cu-Sn alloy, Sn-Ag alloy, Sn-In alloy, Sn-Au alloy, Au-In alloy and Cu-In alloy. The bonding metal layer 25 can be used to bond the epitaxial layer to the substrate 10 by means of eutectic bonding or thermocompression bonding, and the bonding temperature ranges from 100°C to 400°C. Subsequently, the bonding metal layer 25 can be patterned to form a bonding metal pad 24.

In the step 300, the silicon support substrate 70 is removed by hydrofluoric acid.

Before step 400, as shown in FIG. 15, the manufacturing method further includes forming an insulation layer 60 above and between the light emitters 20, and providing openings in the insulation layer 60 above the light emitters 20.

In step 400, as shown in FIG. 13, the first electrode 30 is formed on the insulation layer 60, the first electrode 30 can be a cathode, and the cathode is electrically connected with the light emitters 20 through the openings. In this step, multiple adjacent first electrodes 30 can be connected with each other.

Before step 500, as shown in FIG. 13, the manufacturing method further includes forming a filler 40 between the light emitters 20, and a material of the filler 40 can be white glue or dark-colored glue such as black gray glue.

In step 500, when the at least one microstructure 32 includes a nanostructure 321, the nanostructure 321 is manufactured by: first forming a metal layer on the first electrode 30, and etching the metal layer to form the nanostructure 321; or directly etching the first electrode 30 to form the nanostructure 321.

In step 500, as shown in FIG. 16, the nanostructure 321 is manufactured by: forming a photoresist pattern 80 on a side of the first electrode 30 away from the substrate 10, the photoresist pattern 80 includes a plurality of sub-patterns 81, and a cross-sectional area of each of the plurality of sub-patterns 81 decreases. The first electrode 30 is dry-etched using the photoresist pattern 80 as a mask, and the topography of the photoresist pattern 80 is transferred to the first electrode 30 to form the nanostructure 321.

The shape of the nanostructure 321 manufactured by the above process can be a pyramid shape, the duty ratio f of bottom surface of the pyramid array formed by the plurality of nanostructures 321 is 1, a side length of the bottom surface of the nanostructure 321 ranges from 270 nm to 330 nm, a lattice constant of the nanostructure 321 ranges from 270 nm to 330nm, and a thickness of the nanostructure 321 ranges from 200 nm to 250 nm.

In step 500, the manufacturing method can further include forming an encapsulation layer 50 or a condenser lens 322 on the first electrode 30. And coating UV (Ultraviolet Rays) glue on the encapsulation layer 50 or the condenser lens 322, and bonding a glass cover with UV glue.

The above description is embodiments of the application, and does not limit the application in any form. Although the application has disclosed the above with the embodiments, it is not intended to limit the application. Any technical personnel familiar with this field, within the scope of the technical solution of this application, can make some changes or modify equivalent embodiments using the disclosed technical content. However, any simple modifications, equivalent changes, and modifications made to the above embodiments based on the technical essence of this application, which are not separated from the technical solution of this application, still fall within the scope of the technical solution of this application.

## Claims

1. A display panel, comprising:

   a substrate;
   a light emitter on a side of the substrate;
   a first electrode on a side of the light emitter away from the substrate; and
   a light collimator on a side of the first electrode away from the substrate; wherein the light collimator comprises at least one microstructure; and wherein in a direction away from the substrate, a cross-sectional area of each of the at least one microstructure decreases.

2. The display panel according to claim 1, wherein a filler is provided between adjacent light emitters.

3. The display panel according to claim 2, wherein a distance from a surface of the filler away from the substrate to the substrate is greater than or equal to a distance from a surface of the light collimator away from the substrate to the substrate.

4. The display panel according to claim 2, wherein the filler comprises a reflective material.

5. The display panel according to claim 1, wherein a projection of the light collimator onto the substrate covers at least a projection of the light emitter onto the substrate.

6. The display panel according to claim 1, wherein a plurality of adjacent first electrodes are connected with each other.

7. The display panel according to claim 1, wherein the at least one microstructure comprises a nanostructure and/or a condenser lens.

8. The display panel according to claim 7, wherein the nanostructure comprises a bottom in contact with the first electrode, and bottoms of adjacent nanostructures are connected with one another.

9. The display panel according to claim 7, wherein a material of the first electrode is the same as a material of the nanostructure, and the first electrode is integrally connected with the nanostructure.

10. The display panel according to claim 7, wherein a filler is provided between adjacent light emitters; wherein in a thickness direction of the substrate, a thickness of the nanostructure ranges from 200 nm to 250 nm; and wherein a surface of the filler away from the substrate is at least 250 nm farther away than a surface of the first electrode away from the substrate.

11. The display panel according to claim 7, wherein the condenser lens is a spherical cap, and a projection of the condenser lens onto the substrate covers at least a projection of the light emitter onto the substrate.

12. The display panel according to claim 7, wherein a filler is provided between adjacent light emitters; in a thickness direction of the substrate, a thickness of the condenser lens ranges from 2 $\mu$m to 3 $\mu$m; and a surface of the filler away from the substrate is at least 3 $\mu$m farther away than a surface of the first electrode away from the substrate.

13. The display panel according to claim 1, wherein a material of the substrate comprises a silicon material.

14. The display panel according to claim 1, wherein the light emitter comprises a first semiconductor layer, a light emitting layer and a second semiconductor layer that are stacked in sequence; wherein the light emitting layer comprises a quantum well layer, and the first semiconductor layer is a second electrode.

15. The display panel according to claim 1, further comprising an encapsulation layer, wherein the encapsulation layer is on a side of the light collimator away from the substrate, and is filled between adjacent microstructures, and a refraction index of the encapsulation layer is smaller than a refraction index of the microstructure.

16. The display panel according to claim 1, wherein the substrate comprises a driving circuit layer configured to drive the light emitter.

17. The display panel according to claim 16, wherein the display panel comprises a bonding metal pad disposed between the substrate and the light emitter, and the driving circuit layer is configured to drive the light emitter through the bonding metal pad.

18. A display device, comprising the display panel according to any one of claims 1-17.

19. A method of manufacturing a display panel, the manufacturing method is used to manufacture the display panel according to any one of claims 1-17, wherein the manufacturing method comprises:

forming an epitaxial layer on a side of a support substrate, wherein the epitaxial layer comprises a second semiconductor layer, a light emitting layer, and a first semiconductor layer that are stacked in sequence;
forming a bonding metal layer on a side of the epitaxial layer away from the support substrate;
bonding the epitaxial layer to a substrate by the bonding metal layer;
removing the support substrate, and patterning the epitaxial layer to form a plurality of light emitters;
forming a first electrode on a side of the plurality of light emitters away from the substrate;
forming a light collimator on a side of the first electrode away from the substrate, wherein the light collimator comprises at least one microstructure; and wherein in a direction away from the substrate, a cross-sectional area of each of the at least one microstructure decreases.

20. The manufacturing method according to claim 19, wherein in response to determining that the at least one microstructure comprises a nanostructure, the nanostructure is manufactured by:

first forming a metal layer on the first electrode, and etching the metal layer to form the nanostructure; or
directly etching the first electrode to form the nanostructure.

21. The manufacturing method according to claim 19, wherein in response to determining that the at least one microstructure comprises a nanostructure, the nanostructure is manufactured by:

forming a photoresist pattern on a side of the first electrode away from the substrate, wherein the photoresist pattern comprises a plurality of sub-patterns, and a cross-sectional area of each of the plurality of sub-patterns decreases; and
dry etching the first electrode using the photoresist pattern as a mask, such that a topography of the photoresist pattern is transferred to the first electrode to form the nanostructure.

FIG. 1

FIG. 2

FIG. 3

FIG. 4

FIG. 5

FIG. 6

FIG. 7

FIG. 8

FIG. 9

70
23
22 } 20
21
25
10

FIG. 10

23
22 } 20
21
25
10

FIG. 11

FIG. 12

FIG. 13

FIG. 14

FIG. 15

FIG. 16

## INTERNATIONAL SEARCH REPORT

| International application No. |
| --- |
| **PCT/CN2022/106563** |

| A. | CLASSIFICATION OF SUBJECT MATTER |
| --- | --- |

H01L 33/38(2010.01)i;H01L33/58(2010.01)i

According to International Patent Classification (IPC) or to both national classification and IPC

| B. | FIELDS SEARCHED |
| --- | --- |

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

DWPI, CNKI, IEEE, CNABS, CNTXT, ENTXTC, WPABSC: 准直, 聚光, 透镜, 电极, 支撑, 反射, 纳米, alignment, collimation, condensation, len, electrode, support, reflect, nano

| C. | DOCUMENTS CONSIDERED TO BE RELEVANT | |
| --- | --- | --- |

| Category* | Citation of document, with indication, where appropriate, of the relevant passages | Relevant to claim No. |
| --- | --- | --- |
| X | CN 108987425 A (OMNIVISION SEMICONDUCTOR (SHANGHAI) CO., LTD.) 11 December 2018 (2018-12-11) description, paragraphs 44-86, and figures 1-14 | 1-21 |
| A | CN 112420959 A (BOE TECHNOLOGY GROUP CO., LTD.) 26 February 2021 (2021-02-26) entire document | 1-21 |
| A | KR 20120044719 A (SEOUL OPTO DEVICE CO., LTD.) 08 May 2012 (2012-05-08) entire document | 1-21 |
| A | US 2005199898 A1 (LIN MING-DER et al.) 15 September 2005 (2005-09-15) entire document | 1-21 |
| A | US 2012049223 A1 (YANG JEONG HEE et al.) 01 March 2012 (2012-03-01) entire document | 1-21 |

☐ Further documents are listed in the continuation of Box C.　　☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **17 March 2023** | **20 March 2023** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

<table>
<tr><td colspan="4" align="center">**INTERNATIONAL SEARCH REPORT**<br>Information on patent family members</td><td colspan="2">International application No.<br>**PCT/CN2022/106563**</td></tr>
<tr><td colspan="2" align="center">Patent document<br>cited in search report</td><td align="center">Publication date<br>(day/month/year)</td><td colspan="2" align="center">Patent family member(s)</td><td align="center">Publication date<br>(day/month/year)</td></tr>
<tr><td>CN</td><td>108987425 A</td><td>11 December 2018</td><td>US</td><td>2020027865 A1</td><td>23 January 2020</td></tr>
<tr><td></td><td></td><td></td><td>US</td><td>10607974 B2</td><td>31 March 2020</td></tr>
<tr><td></td><td></td><td></td><td>TWI</td><td>673863 B</td><td>01 October 2019</td></tr>
<tr><td></td><td></td><td></td><td>TW</td><td>202008577 A</td><td>16 February 2020</td></tr>
<tr><td></td><td></td><td></td><td>CN</td><td>108987425 B</td><td>18 September 2020</td></tr>
<tr><td>CN</td><td>112420959 A</td><td>26 February 2021</td><td>US</td><td>2022158137 A1</td><td>19 May 2022</td></tr>
<tr><td>KR</td><td>20120044719 A</td><td>08 May 2012</td><td>KR</td><td>101272708 B1</td><td>10 June 2013</td></tr>
<tr><td>US</td><td>2005199898 A1</td><td>15 September 2005</td><td>TW</td><td>200531310 A</td><td>16 September 2005</td></tr>
<tr><td>US</td><td>2012049223 A1</td><td>01 March 2012</td><td>WO</td><td>2012026695 A2</td><td>01 March 2012</td></tr>
<tr><td></td><td></td><td></td><td>WO</td><td>2012026695 A3</td><td>31 May 2012</td></tr>
<tr><td></td><td></td><td></td><td>US</td><td>2014299905 A1</td><td>09 October 2014</td></tr>
<tr><td></td><td></td><td></td><td>US</td><td>8878220 B2</td><td>04 November 2014</td></tr>
</table>

Form PCT/ISA/210 (patent family annex) (July 2022)